# EUROPEAN PATENT APPLICATION

(11) **EP 2 369 629 A1**
(43) Date of publication of application: **28.09.2011**
(21) Application number: 10401039.2
(22) Date of filing: 25.03.2010
(51) Int. Cl.: H01L 31/0224, C25D 5/02

(54) **Method of manufacturing electrical contacts of a silicon solar cell structure.**

(71) Applicant: Roth & Rau AG, 09337 Hohenstein-Ernstthal (DE)
(72) Inventor: Böhme, Rico, 09306 Rochiltz (DE); Andrault, Yoann, 2013 Colombier (CH); Buechel, Arthur, 9491 Ruggell (LI); Papet, Pierre, 38660 Le Touvet (FR)
(74) Representative: Steiniger, Carmen

(57) **Abstract**

The present invention relates to a method of manufacturing at least one electrical contact of a silicon solar cell structure, wherein a layer on a semiconductor substrate is patterned by laser patterning and at least one metal contact is formed on the patterned structure. It is the object of the present invention to provide a method of manufacturing at least one electrical contact of a silicon solar cell structure with an enhanced speed and uniformity. The object is solved by a method of the above mentioned type wherein the method comprising the steps of: providing a silicon substrate; forming at least one silicon layer on at least one side of the silicon substrate, wherein the silicon substrate and the silicon layer are doped in such a way that a p-n junction is formed between the silicon substrate and the silicon layer; forming at least one transparent conductive oxide (TCO) layer on the at least one silicon layer; forming a metal oxide or carbide layer on the TCO layer, wherein the metal oxide or carbide layer has a lower conductance than the TCO layer; patterning the metal oxide or carbide layer by laser patterning; and forming at least one metal contact on the patterned metal oxide or carbide layer by single-sided plating, wherein the negative plating terminal is electrically connected to the n-doped silicon side of the p-n junction being on the side opposite to the side of the structure where the at least one metal contact is formed, so that the solar cell structure is operated in forward bias mode during plating.

## Description

The present invention relates to a method of manufacturing at least one electrical contact of a silicon solar cell structure, wherein a layer on a semiconductor substrate is patterned by laser patterning and at least one metal contact is formed on the patterned structure.

A method of the above mentioned type is known from the published German patent application DE 10 2008 019 725 A. The known method starts with a formation of a passivation layer of SiO₂ or Si₃N₄ on the front and/or the back side of a semiconductor substrate. Thereafter, both sides of the substrate are covered with a resist layer. Then, a pattern is formed on one side of the structure by a laser ablation of certain areas of the resist layer and of the underlying passivation layer. After opening of the passivation layer, a metal layer is deposited on the masked structure, for instance using a galvanic process. In this process, the mask consisting of the patterned resist and passivation layer prevents an enlargement of the contact structure over the dimensions defined by the openings in the mask. Finally, the mask is removed.

This process uses a conventional mask technology comprising several auxiliary mask layer deposition steps, a mask patterning, the metal deposition and a removal of the auxiliary layers to define and produce the electrical contacts, wherein the metal deposition step suffers from a relatively low deposition rate and from irregularities in the thickness of the deposited metal layer.

It is therefore the object of the present invention to provide a method of manufacturing at least one electrical contact of a silicon solar cell structure with an enhanced speed and uniformity.

The object is solved by a method of manufacturing at least one electrical contact of a silicon solar cell structure, wherein a layer on a semiconductor substrate is patterned by laser patterning and at least one metal contact is formed on the patterned structure, and wherein the method comprising the steps of: providing a silicon substrate; forming at least one silicon layer on at least one side of the silicon substrate, wherein the silicon substrate and the silicon layer are doped in such a way that a p-n junction is formed between the silicon substrate and the silicon layer; forming at least one transparent conductive oxide (TCO) layer on the at least one silicon layer; forming a metal oxide or carbide layer on the TCO layer, wherein the metal oxide or carbide layer has a lower conductance than the TCO layer; patterning the metal oxide or carbide layer by laser patterning; and forming at least one metal contact on the patterned metal oxide or carbide layer by single-sided plating, wherein the negative plating terminal is electrically connected to the n-doped silicon side of the p-n junction being on the side opposite to the side of the structure where the at least one metal contact is formed, so that the solar cell structure is operated in forward bias mode during plating.

The present invention uses the effect that the metal plating process can be enhanced by using the current flowing through the forwardly biased solar cell structure. Thus, by a simple electrical connection of the side opposite to the contact formation side with the negative potential, the positively charged metal ions in the galvanic bath migrate in a fast and reliable way to these areas on the contact formation side which were preliminarily defined by the laser patterning step. This procedure is possible because there is a continuous current path through the structure which is not existent in other known technologies where insulating layer(s) and/or reverse biased p-n junctions are formed on or in the structure. The present invention has furthermore the advantage that the patterned metal oxide or carbide layer has not to removed, but can be used further as a functional part of the silicon solar cell structure.

According to a favorite embodiment of the present invention, the step of laser patterning comprises laser ablation of parts of the metal oxide or carbide layer. The laser ablation step can provide with a high effectiveness openings in the metal oxide or carbide layer with a very high accuracy and with nearly vertical side walls of the openings in the metal oxide or carbide layer. Because of the low conductance of the metal oxide or carbide layer in comparison with the higher conductance of the underlying TCO layer, the metal ions deposit only on opened areas to the higher conductive TCO layer during the metal plating step and fill the openings wherein the patterned metal oxide or carbide layer serves as a mask for this plating process.

In an alternative variant of the present invention, the step of laser patterning comprises laser-induced increase of conductance of the metal oxide or carbide layer. It has been shown that it is possible to influence the electrical properties of the metal oxide or carbide layer with laser irradiation. The exposure to laser radiation, especially using a short laser excitation and a short disexcitation, leads in that material to laser induced lattice imperfections and the formation of free bonds in the disordered system and therefore to an increased conductance of the metal oxide or carbide layer. In this way, the conductance can be increased in the laser radiated areas of the metal oxides or carbide layer, wherein in the non-radiated areas of this layer the conductance stays low. This leads to the advantage that the metal ions only settle on the areas with the higher conductance to form there the electrical contact(s) during the plating step.

In a beneficial example of the present invention, the metal oxide or carbide layer is a TCO layer such as Indium Tin Oxide (ITO), Fluor Tin Oxide (FTO), Aluminum Zinc Oxide (AZO) or Antimony Tin Oxide (ATO), a metal oxide such as FeO or Al₂O₃, or a carbide such as TiC or SiC. These materials can be on one hand easily removed by laser ablation. On the other hand, these materials are favorably suited for a modification of their conductance by the influence of a laser. Furthermore, especially the suggested TCO layer have the advantage that they can be formed on the underlying TCO layer with a high similarity of the layer properties resulting in a good adhesion and similar optical transparency as the underlying TCO layer.

During the step of laser patterning, it is especially advantageous to use a laser working in the deep UV with a wavelength being below 355 nm, favorably below 200 nm. The suggested lasers have a wavelength allowing an energy absorption by the material of the metal oxide or carbide layer to make it possible to ablate or to modify said layer. These lasers work typically with pulse durations of an order between 0.4 ps and 100 ns.

According to another variant of the present invention, laser pulses with an intensity of more than 10¹⁵ W/cm² are applied. These specific lasers provide much smaller pulse durations than the above mentioned lasers. Although such high-intensity lasers work typically in an IR region with wavelength for which the material of the metal oxide or carbide layer is normally transparent, by the very quick pulses of these lasers (pulse durations in the region of Pico- until Femtos) it is possible to induce for instance avalanche effects in the layer leading to a disordering of the layer structure and to a change of the electrical layer properties.

High accuracy laser patterning results can be achieved with the present invention if the step of laser patterning comprises the application of a laser working with a shielding gas. In doing so, the laser can be applied on the structure without external disturbances.

Furthermore, the contact formation can be enhanced in the present invention if the at least one metal contact is sintered after the plating step.

The object can be further solved by a method of manufacturing at least one electrical contact of a silicon solar cell structure, wherein a layer on a semiconductor substrate is patterned by laser patterning and at least one metal contact is formed on the patterned structure, and wherein the method comprising the steps of: providing a silicon substrate; forming at least one silicon layer on at least one side of the silicon substrate, wherein the silicon substrate and the silicon layer are doped in such a way that a p-n junction is formed between the silicon substrate and the silicon layer; forming at least one transparent conductive oxide (TCO) layer on the at least one silicon layer; forming a metal oxide or carbide layer on the TCO layer, wherein the metal oxide or carbide layer has a lower conductance than the TCO layer; patterning the metal oxide or carbide layer by laser patterning, wherein the laser patterning step comprises laser-induced increase of conductance of the metal oxide or carbide layer; and forming at least one metal contact on the patterned metal oxide or carbide layer by single-sided metal plating or by metal printing and firing.

This kind of method can be advantageously combined with one or more of the above described method specifications. In particular, favorable materials for the formation of the metal oxide or carbide layer can be a TCO layer such as Indium Tin Oxide (ITO), Fluor Tin Oxide (FTO), Aluminum Zinc Oxide (AZO) or Antimony Tin Oxide (ATO), a metal oxide such as FeO or Al₂O₃, or a carbide such as TiC or SiC, leading to the above mentioned advantages. Moreover, this method can be carried out using the above described lasers with the corresponding suggested laser wavelengths, intensities and/or additional precautions like a gas shielding. In this kind of method, it is not absolutely necessary that the silicon solar cell structure is operated in forward bias mode during the contact formation. Instead, the metal layer is printed onto the laser-patterned surface of the structure, wherein the metal diffuses during the firing step from the printed layer to the laser-modified areas of the metal oxide or carbide layer where the conductance of said layer is increased by the influence of the laser as described above.

In the following, advantageous embodiments of the present invention are explained in further detail in terms of the figures, wherein
- Fig. 1: schematically shows a step of an embodiment of the method of the present invention, wherein the step comprises the providing of a silicon substrate with silicon layers and TCO layers;
- Fig. 2: schematically shows a further step of the inventive method, wherein said step comprises the formation of a metal oxide or carbide layer on a surface of the structure of Fig. 1;
- Fig. 3: schematically shows a laser ablation step applied on the structure of Fig. 2 in accordance with a step variant of an embodiment of the inventive method;
- Fig. 4: schematically shows a metal plating step applied on the structure shown in Fig. 3 in accordance with a step of an embodiment of the inventive method;
- Fig. 5: schematically shows a laser-induced increase of conductance of the metal oxide or carbide layer of surface areas of the structure of Fig. 2 in accordance with a further step variant of an embodiment of the inventive method; and
- Fig. 6: schematically shows a metal plating step applied on the structure shown in Fig. 5 in accordance with another step of an embodiment of the inventive method.

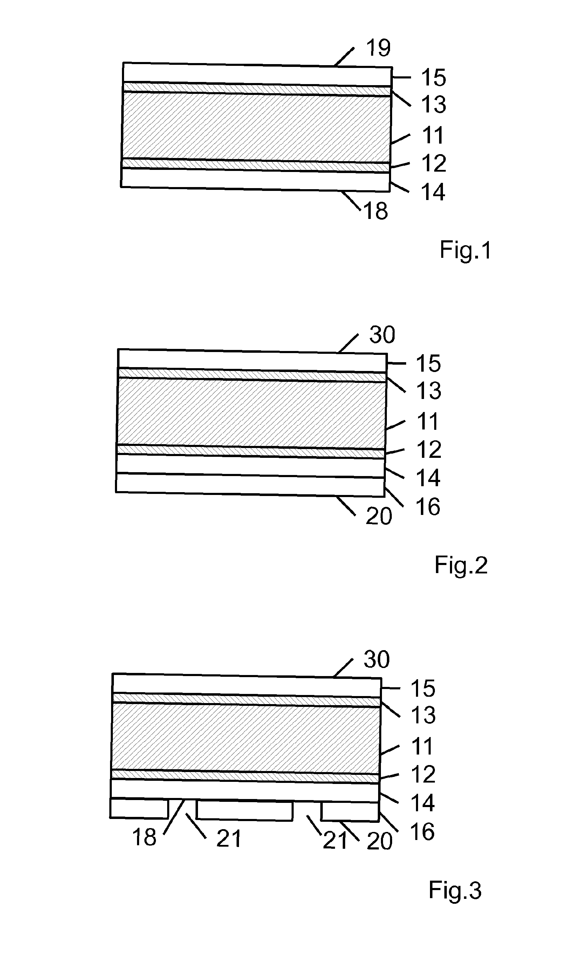

The present invention comprises a method of manufacturing at least one electrical contact 7 of a silicon solar cell structure. The method comprises several steps, wherein some of these steps and step variants are shown in the Figs. 1 to 6. It is to be understood that the Figs. 1 to 6 show the respective structure only schematically, wherein the shown details are not drawn true to scale and are concentrated to such elements which are advantageous to illustrate the present invention.

Fig. 1 schematically shows a silicon substrate 11. Both sides of the silicon substrate 11 are covered with a silicon layer 12, 13. In the example shown, the silicon layers 12, 13 are amorphous silicon layers. In other not shown examples of the present invention, the silicon layers 12, 13 can also be polycrystalline or crystalline silicon layers. Furthermore, in other embodiments of the present invention, only one silicon layer (12 or 13) is formed on one of the sides of the silicon substrate 11.

In the example of Fig. 1, on the silicon layers 12, 13, on both sides of the substrate 11, a transparent and conductive oxide (TCO) layer 14, 15 is formed. The TCO layer 14, 15 is electrically conductive and consists exemplarily of, but is not restricted to materials such as Indium Tin Oxide (ITO), Fluor Tin Oxide (FTO), Aluminum Zinc Oxide (AZO) or Antimony Tin Oxide (ATO).

As schematically shown in Fig. 2, on the TCO layer 14 formed on the front side 18 of the structure shown in Fig. 1, a metal oxide or carbide layer 16 is formed. The metal oxide or carbide layer 16 has is non-conductive or has a lower conductance than the TCO layer 14. The metal oxide or carbide layer 16 consists exemplarily of a TCO layer such as Indium Tin Oxide (ITO), Fluor Tin Oxide (FTO), Aluminum Zinc Oxide (AZO) or Antimony Tin Oxide (ATO), a metal oxide such as FeO or Al₂O₃, or a carbide such as TiC or SiC.

With reference to Fig. 3, in a further step a laser patterning is applied on the front side 20 of the structure of Fig. 2. In the variant shown, the laser patterning step comprises a laser ablation of certain areas of the metal oxide or carbide layer 16 leading to the formation of openings 21 in the metal oxide or carbide layer 16. The laser ablation process creates channel-like openings 21 with high accuracy and nearly vertical side walls of the openings 21. In the openings 21, the surface 18 of the conductive TCO layer 14 is open.

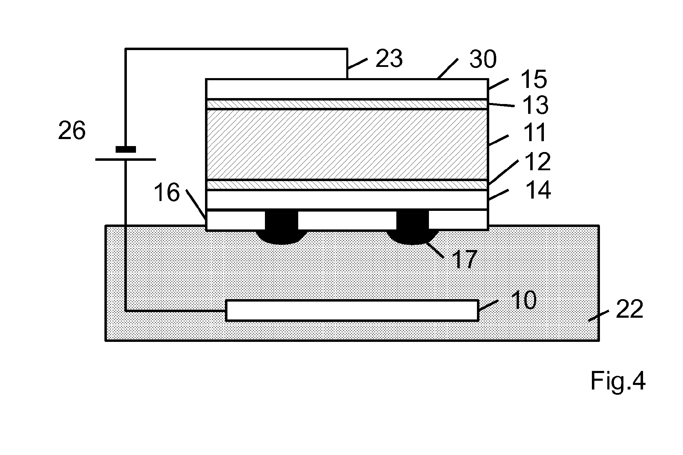

Fig. 4 shows schematically a metal plating step according to a next step of the method of the present invention. In that step, the structure of Fig. 3 is immersed in a plating bath 22, wherein an electrode 10 with a positive electrical potential is arranged in the bath 22 and wherein a terminal 23 with a negative electrical potential of a power supply unit 26 is connected with the electrically conductive TCO layer 15 on the back side 19 of the structure. The bath 22 contains a solution with metal ions which are positively charged. The silicon substrate 11 and the silicon layers 12, 13 are doped in such a way that the silicon solar cell structure connected as shown in Fig. 4 is operated in forward bias mode. Therefore, an electrical current flows between the terminal 23 and the electrode 10 in the bath 22. That leads to the effect that the metal ions in the bath flow to and deposit on the electrically conductive surface 18 of the TCO layer 14 in the openings 21. In this way, during the plating step of Fig. 4, metal layers 17 grow in the openings 21 and form contacts. The contact formation is due to the continuous current between the terminal 23 and the electrode 10 relatively quick and homogenous.

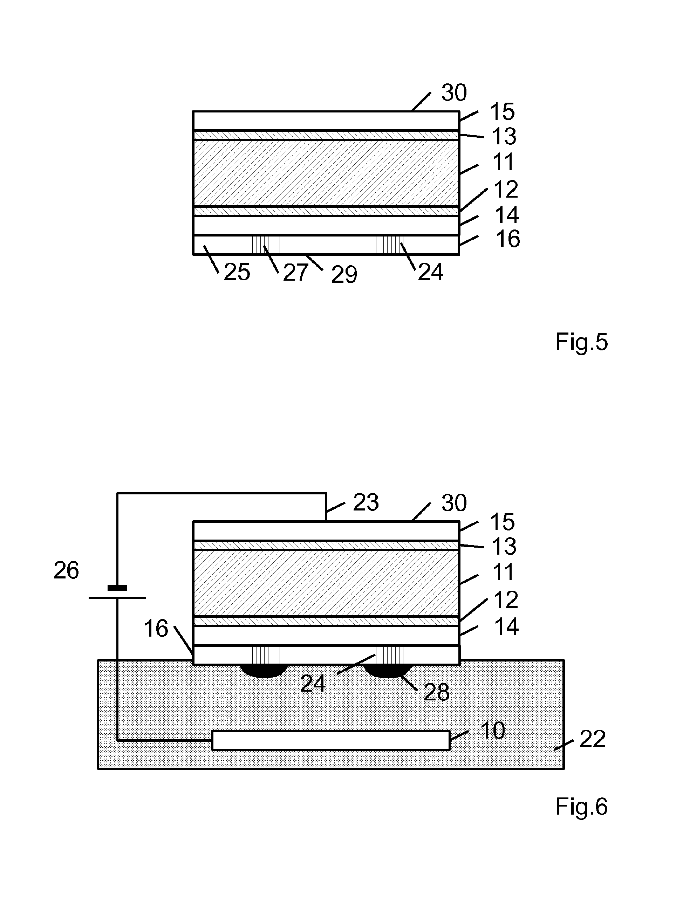

Fig. 5 shows in contrary to Fig. 3 schematically a laser patterning step according to another possible variant of the method of the present invention. The step shown in Fig. 5 follows the step shown in Fig. 2.

The laser patterning step of Fig. 5 comprises a laser-induced modification of the metal oxide or carbide layer 16 in the areas which are radiated by the laser. The laser-induced modification leads to modified areas 24 with an increased electrical conductance of the metal oxide or carbide layer 16 as described above, wherein the regions 25 of the metal oxide or carbide layer 16 which are not laser-modified have a low conductance or are not electrically conductive as the originally formed metal oxide or carbide layer 16.

As schematically shown in Fig. 6, the structure of Fig. 5 is plated in a next step in a plating bath 22. As described above with reference to Fig. 4, the plating bath 22 comprises a solution with positively charged metal ions, wherein an electrode 10 connected with the positive terminal of a power supply unit 26 is arranged in the bath 22. The negative terminal 23 of the power supply unit 26 is connected with the electrically conductive TCO layer 15 on the back side 19 of the shown silicon solar cell structure.

The silicon substrate 11 and the silicon layers 12, 13 are doped in such a way that the silicon solar cell structure connected as shown in Fig. 6 is operated in forward bias mode. Therefore, an electrical current flows between the terminal 23 and the electrode 10 in the bath 22. That leads to the effect that the metal ions in the bath 22 flow to and deposit on the electrically conductive surface 27 of the laser-induced modified areas 24 of the metal oxide or carbide layer 16. In this way, during the plating step of Fig. 6, metal layers 28 grow on the modified areas 24 and form contacts. The contact formation is due to the continuous current between the terminal 23 and the electrode 10 relatively quick and high thickness homogeneity.

In another not shown embodiment of the present invention, the structure shown in Fig. 5 can be provided with metal contacts by the following steps: First, at least one metal layer is screen printed on the front side 29 of the structure of Fig. 5. Then, a firing step is applied on the structure, wherein at high temperature the metal atoms of the printed metal layer diffuse to electrically conductive surface 27 into the material of the laser-induced modified areas 24 and form there highly conductive electrical contact(s). Thereafter, the metal layer on the surface can be removed.

## Claims

1. Method for manufacturing at least one electrical contact of a silicon solar cell structure, wherein a layer on a semiconductor substrate is patterned by laser patterning and at least one metal contact is formed on the patterned structure,
**characterized in that**
the method comprising the steps of:
providing a silicon substrate (11);
forming at least one silicon layer (12, 13) on at least one side of the silicon substrate (11), wherein the silicon substrate (11) and the silicon layer (12, 13) are doped in such a way that a p-n junction is formed between the silicon substrate (11) and the silicon layer (12, 13);
forming at least one transparent conductive oxide (TCO) layer (14, 15) on the at least one silicon layer (12, 13);
forming a metal oxide or carbide layer (16) on the TCO layer (14, 15), wherein the metal oxide or carbide layer (16) has a lower conductance than the TCO layer (14, 15);
patterning the metal oxide or carbide layer (16) by laser patterning; and
forming at least one metal contact (17) on the patterned metal oxide or carbide layer (16) by single-sided plating, wherein
the negative plating terminal is electrically connected to the n-doped silicon side of the p-n junction being on the side opposite to the side of the structure where the at least one metal contact (17) is formed, so that the solar cell structure is operated in forward bias mode during plating.

2. Method of claim 1, **characterized in that** the step of laser patterning comprises laser ablation of parts of the metal oxide or carbide layer (16).

3. Method of claim 1, **characterized in that** the step of laser patterning comprises laser-induced increase of conductance of the metal oxide or carbide layer (16).

4. Method of at least one of the preceding claims, **characterized in that** the metal oxide or carbide layer (16) is a TCO layer such as Indium Tin Oxide (ITO), Fluor Tin Oxide (FTO), Aluminum Zinc Oxide (AZO) or Antimony Tin Oxide (ATO), a metal oxide such as FeO or Al₂O₃, or a carbide such as TiC or SiC.

5. Method of at least one of the preceding claims, **characterized in that** the step of laser patterning comprises the application of a laser wavelength being below 355 nm, favorably below 200 nm.

6. Method of at least one of the preceding claims, **characterized in that** laser pulses with an intensity of more than 10¹⁵ W/cm² are applied during the step of laser patterning.

7. Method of at least one of the preceding claims, **characterized in that** the step of laser patterning comprises the application of a laser working with a shielding gas.

8. Method of at least one of the preceding claims, **characterized in that** the at least one metal contact (17) is sintered after the plating step.

## Amended claims

### Amended claims in accordance with Rule 137(2) EPC.

**1.** Method for manufacturing at least one electrical contact of a silicon solar cell structure, wherein a layer on a semiconductor substrate is patterned by laser patterning and at least one metal contact is formed on the patterned structure,
**characterized in that**
the method comprising the steps of:
providing a silicon substrate (11);
forming at least one silicon layer (12, 13) on at least one side of the silicon substrate (11), wherein the silicon substrate (11) and the silicon layer (12, 13) are doped in such a way that a p-n junction is formed between the silicon substrate (11) and the silicon layer (12, 13);
forming at least one transparent conductive oxide (TCO) layer (14, 15) on the at least one silicon layer (12, 13);
forming a metal oxide or carbide layer (16) on the TCO layer (14, 15), wherein the metal oxide or carbide layer (16) has a lower conductance than the TCO layer (14, 15);
patterning the metal oxide or carbide layer (16) by laser patterning, wherein the step of laser patterning comprises laser ablation of parts of the metal oxide or carbide layer (16); and
forming at least one metal contact (17) on the patterned metal oxide or carbide layer (16) by single-sided electroplating, wherein
the negative plating terminal is electrically connected to the n-doped silicon side of the p-n junction being on the side opposite to the side of the structure where the at least one metal contact (17) is formed, so that the solar cell structure is operated in forward bias mode during electroplating.

**2.** Method for manufacturing at least one electrical contact of a silicon solar cell structure, wherein a layer on a semiconductor substrate is patterned by laser patterning and at least one metal contact is formed on the patterned structure,
**characterized in that**
the method comprising the steps of:
providing a silicon substrate (11);
forming at least one silicon layer (12, 13) on at least one side of the silicon substrate (11), wherein the silicon substrate (11) and the silicon layer (12, 13) are doped in such a way that a p-n junction is formed between the silicon substrate (11) and the silicon layer (12, 13);
forming at least one transparent conductive oxide (TCO) layer (14, 15) on the at least one silicon layer (12, 13);
forming a metal oxide or carbide layer (16) on the TCO layer (14, 15), wherein the metal oxide or carbide layer (16) has a lower conductance than the TCO layer (14, 15);
patterning the metal oxide or carbide layer (16) by laser patterning, wherein the step of laser patterning comprises laser-induced increase of conductance of the metal oxide or carbide layer (16); and
forming at least one metal contact (17) on the patterned metal oxide or carbide layer (16) by single-sided electroplating, wherein
the negative plating terminal is electrically connected to the n-doped silicon side of the p-n junction being on the side opposite to the side of the structure where the at least one metal contact (17) is formed, so that the solar cell structure is operated in forward bias mode during electroplating.

**3.** Method of at least one of the preceding claims, **characterized in that** the metal oxide or carbide layer (16) is a TCO layer such as Indium Tin Oxide (ITO), Fluor Tin Oxide (FTO), Aluminum Zinc Oxide (AZO) or Antimony Tin Oxide (ATO), a metal oxide such as FeO or Al₂O₃, or a carbide such as TiC or SiC.

**4.** Method of at least one of the preceding claims, **characterized in that** the step of laser patterning comprises the application of a laser wavelength being below 355 nm, favorably below 200 nm.

**5.** Method of at least one of the preceding claims, **characterized in that** laser pulses with an intensity of more than 10¹⁵ W/cm² are applied during the step of laser patterning.

**6.** Method of at least one of the preceding claims, **characterized in that** the step of laser patterning comprises the application of a laser working with a shielding gas.

**7.** Method of at least one of the preceding claims, **characterized in that** the at least one metal contact (17) is sintered after the electroplating step.
